# EUROPEAN PATENT APPLICATION

(11) **EP 4 024 450 A1**
(43) Date of publication of application: **06.07.2022**
(21) Application number: 19947913.0
(22) Date of filing: 30.09.2019
(51) Int. Cl.: H01L 25/065, H01L 23/528

(54) **STACKED CHIP PACKAGE AND TERMINAL DEVICE**

(71) Applicant: Huawei Technologies Co., Ltd., Longgang District Shenzhen, Guangdong 518129 (CN)
(72) Inventor: ZHANG, Xiaodong, Shenzhen, Guangdong 518129 (CN); ZHANG, Tonglong, Shenzhen, Guangdong 518129 (CN); LI, Heng, Shenzhen, Guangdong 518129 (CN); WANG, Simin, Shenzhen, Guangdong 518129 (CN)
(74) Representative: Gill Jennings & Every LLP
(86) International application number: PCT/CN2019/109660
(87) International publication number: WO 2021/062742

(57) **Abstract**

This application provides a chip stacking package and a terminal device, and relates to the field of semiconductor technologies. The chip stacking package can resolve a problem of high costs caused by using a through silicon via technology while ensuring a power supply requirement. The chip stacking package (01) includes a first chip (101) and a second chip (102) disposed between a first routing structure (10) and a second routing structure (20). An active surface (S1) of the first chip (101) faces an active surface (S2) of the second chip (102). The active surface (S1) of the first chip (101) includes a first overlapping region (A1) and a first non-overlapping region (C1). The active surface (S2) of the second chip (102) includes a second overlapping region (A2) and a second non-overlapping (C2) region. The first overlapping region (A1) overlaps the second overlapping region (A2), and the first overlapping region (A1) is connected to the second overlapping region (A2). The first non-overlapping region (C1) is connected to the second routing structure (20). The second non-overlapping region (C2) is connected to the first routing structure (10).

## Description

### TECHNICAL FIELD

This application relates to the field of semiconductor technologies, and in particular, to a chip stacking package and a terminal device.

### BACKGROUND

With development of semiconductor technologies, electronic devices tend to be thin and light, and more performance and features are integrated into smaller space. Therefore, a chip packaging technology becomes more important in an electronic device industry chain. A 3D IC (3-dimensional integrated circuit) packaging technology can greatly improve a package integration level, and reduce a package dimension; and currently becomes a mainstream packaging technology.

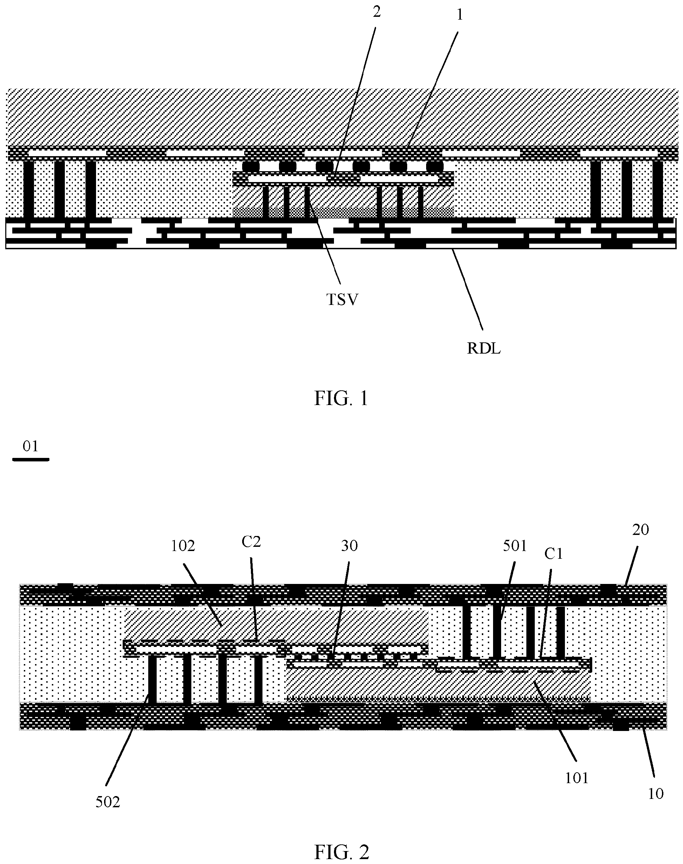

As shown in FIG. 1, in a related 3D IC packaging technology, a dielectric material is used to pad around two chips, and a top-layer chip 1 is connected to a fan-out type redistribution layer (RDL) at the bottom, to ensure power supply for the top-layer chip 1. However, a location of a bottom-layer chip 2 blocks a part of the top-layer chip 1. A power supply requirement for the top-layer chip 1 cannot be met only by disposing a copper column and a bottom RDL connection in a non-blocked region. Therefore, a through silicon via (TSV) needs to be disposed in the bottom-layer chip 2 to connect the top chip 1 and the bottom RDL.

However, a design process of the TSV is complex, which greatly increases process costs of a chip package. Therefore, for the chip package, how to avoid using a TSV technology to reduce manufacturing costs while a power supply requirement needs to be ensured has become a current problem that needs to be resolved.

### SUMMARY

This application provides a chip stacking package and a terminal device, to resolve a problem of high costs caused by using a through silicon via technology while ensuring a power supply requirement.

According to a first aspect, this application provides a chip stacking package, including: a first routing structure and a second routing structure that are disposed opposite to each other, and a first chip and a second chip that are disposed between the first routing structure and the second routing structure. The first chip is in contact with the first routing structure. The second chip is disposed between the second routing structure and the first chip. An active surface of the first chip faces an active surface of the second chip. The active surface of the first chip includes a first overlapping region and a first non-overlapping region, and the active surface of the second chip includes a second overlapping region and a second non-overlapping region. The first overlapping region overlaps the second overlapping region, and the first overlapping region is connected to the second overlapping region. The first non-overlapping region does not overlap the active surface of the second chip. The first non-overlapping region is connected to the second routing structure. The second non-overlapping region does not overlap the active surface of the first chip. The second non-overlapping region is connected to the first routing structure.

In the chip stacking package in this embodiment of this application, the active surface of the first chip is disposed to face the active surface of the second chip, and the first overlapping region on the active surface of the first chip and the second overlapping region on the active surface of the second chip are overlapped and connected. In addition, the second non-overlapping region of the second chip is further disposed not to overlap the active surface of the first chip, and the first non-overlapping region of the first chip does not overlap the active surface of the second chip. In this way, the first chip does not completely block the active surface of the second chip, the second chip does not completely block the active surface of the first chip, the first chip can be connected to the first routing structure to supply power without using a through silicon via, and the second chip can be connected to the first routing structure to supply power without using the through silicon via. Therefore, the chip stacking package in this application can meet power supply requirements of two chips. This avoids a problem of high process costs caused by using a through silicon via technology.

With reference to the first aspect, in a possible implementation, the first overlapping region and the second overlapping region are connected by using a direct interconnection structure, and the direct interconnection structure is a shortest interconnection structure connecting the first overlapping region and the second overlapping region.

In this embodiment of this application, the shortest interconnection structure is disposed between the first overlapping region and the second overlapping region, so that an interconnection path between the first chip and the second chip is the shortest. This improves a communications rate between the first chip and the second chip.

With reference to the first aspect, in a possible implementation, the direct interconnection structure includes a first micro-bump disposed in the first overlapping region, and a second micro-bump or a solder pad that is connected to the first micro-bump by using solder and that is disposed in the second overlapping region.

With reference to the first aspect, in a possible implementation, the direct interconnection structure includes a first solder pad disposed in the first overlapping region, and a second solder pad that is connected to the first solder pad and that is disposed in the second overlapping region. A connection manner of the first solder pad and the second solder pad includes hybrid bonding, surface activated bonding, or atomic diffusion bonding.

With reference to the first aspect, in a possible implementation, the chip stacking package further includes a third chip. An active surface of the third chip faces the active surface of the second chip. The active surface of the third chip includes a third overlapping region and a third non-overlapping region. A first partial region in the second overlapping region overlaps the first overlapping region, and a second partial region in the second overlapping region overlaps the third overlapping region. The third overlapping region is connected to the second partial region, and the first overlapping region is connected to the first partial region. The second non-overlapping region does not overlap the active surface of the third chip. The third non-overlapping region does not overlap the active surface of the second chip. The third non-overlapping region is connected to the second routing structure.

With reference to the first aspect, in a possible implementation, the first non-overlapping region is connected to the second routing structure by using a vertical interconnection structure, or the first non-overlapping region is connected to the first routing structure by using wire bonding.

With reference to the first aspect, in a possible implementation, the first routing structure and the second routing structure are connected by using the vertical interconnection structure, and the vertical interconnection structure is one or a combination of a micro-bump, a copper pillar, a solder ball, and a controlled collapse chip connection structure.

With reference to the first aspect, in a possible implementation, the first chip is disposed in the first routing structure in an embedded manner.

In this embodiment of this application, the first chip is embedded in the first routing structure to reduce a thickness of the chip stacking package.

With reference to the first aspect, in a possible implementation, the first routing structure is a redistribution layer or a substrate on which a cabling pattern is disposed, and the second routing structure is the redistribution layer or the substrate on which the cabling pattern is disposed.

According to a second aspect, this application further provides a terminal device, including a printed circuit board and at least one chip stacking package according to any one of the first aspect and the possible implementations of the first aspect, where the chip stacking package is connected to the printed circuit board by using a connector.

According to a third aspect, this application further provides a chip stacking packaging method, including: disposing a first routing structure and a first chip that is in contact with the first routing structure, and bonding a second chip to the first chip. An active surface of the second chip faces an active surface of the first chip, and the active surface of the first chip includes a first overlapping region and a first non-overlapping region. The active surface of the second chip includes a second overlapping region and a second non-overlapping region. The first non-overlapping region does not overlap the active surface of the second chip. The second non-overlapping region does not overlap the active surface of the first chip. The first overlapping region overlaps the second overlapping region, and the first overlapping region is connected to the second overlapping region. The second non-overlapping region is connected to the first routing structure. The second routing structure is disposed on the second chip. The first non-overlapping region is connected to the second routing structure.

With reference to the third aspect, in a possible implementation, the first routing structure is a first redistribution layer. The disposing a first routing structure and a first chip that is in contact with the first routing structure includes: sequentially forming a temporary bonding layer, the first redistribution layer on a carrier, and attaching the first chip to the first redistribution layer; forming a temporary bonding layer on a carrier, disposing the first chip on the temporary bonding layer, and forming the first redistribution layer on the temporary bonding layer on which the first chip is disposed; or forming a temporary bonding layer on a carrier, forming a partial cabling layer in the first redistribution layer on the temporary bonding layer, attaching the first chip to the partial cabling layer, and forming a remaining cabling layer in the first redistribution layer on the partial cabling layer to which the first chip is attached.

With reference to the third aspect, in a possible implementation, the first routing structure is a first substrate on which a cabling pattern is disposed, and the disposing a first routing structure and a first chip that is in contact with the first routing structure includes: manufacturing the first substrate on which the cabling pattern is disposed, and attaching the first chip to the first substrate.

With reference to the third aspect, in a possible implementation, before the bonding a second chip to the first chip, the method further includes: manufacturing, in the second non-overlapping region, a vertical interconnection structure connected to the first routing structure, or manufacturing, in the first routing structure, a vertical interconnection structure connected to the second non-overlapping region.

In conclusion, in the chip stacking package of this application, the second non-overlapping region of the second chip is disposed not to overlap the active surface of the first chip, and the first non-overlapping region of the first chip is disposed not to overlap the active surface of the second chip. That is, the first chip does not completely block the active surface of the second chip, and the second chip does not completely block the active surface of the first chip. This ensures that the first non-overlapping region of the first chip can be connected to the first routing structure by using wire bonding to supply power, or the first non-overlapping region of the first chip is connected to the second routing structure by using the vertical interconnection structure to supply power, that is, power can be supplied to the first chip without using a through silicon via. The second non-overlapping region of the second chip can be connected to the first routing structure to supply power without using the through silicon via. Therefore, the through silicon via technology is not applied while the power supply requirement is ensured, and process costs are reduced. In addition, in the chip stacking package of this application, the active surface of the first chip is disposed to face the active surface of the second chip, and the first overlapping region on the active surface of the first chip and the second overlapping region on the active surface of the second chip are overlapped and connected by using the direct interconnection structure. Therefore, an interconnection path between the first chip and the second chip is shortened, a signal delay is reduced, and an inter-chip communications rate is improved.

### BRIEF DESCRIPTION OF DRAWINGS

To describe the technical solutions in embodiments of this application or in the background more clearly, the following briefly describes the accompanying drawings used in embodiments of this application or the background.
FIG. 1 is a schematic diagram of a structure of a chip stacking package according to a related technology of this application;
FIG. 2 is a schematic diagram of a structure of a chip stacking package according to an embodiment of this application;
FIG. 3 is a locally enlarged schematic diagram of FIG. 2;
FIG. 4 is a schematic diagram of a structure of a chip stacking package according to an embodiment of this application;
FIG. 5a is a schematic diagram of a structure of a first chip and a second chip in a chip stacking package according to an embodiment of this application;
FIG. 5b is a schematic diagram of a structure of a first chip and a second chip in a chip stacking package according to an embodiment of this application;
FIG. 5c is a schematic diagram of a structure of a first chip and a second chip in a chip stacking package according to an embodiment of this application;
FIG. 6 is a schematic diagram of a structure of a chip stacking package according to an embodiment of this application;
FIG. 7 is a schematic diagram of a structure of a chip stacking package according to an embodiment of this application;
FIG. 8 is a schematic diagram of a structure of a chip stacking package according to an embodiment of this application;
FIG. 9 is a schematic diagram of a structure of a chip stacking package according to an embodiment of this application;
FIG. 10 is a schematic diagram of a structure of a chip stacking package according to an embodiment of this application;
FIG. 11a is a schematic diagram of a structure of a chip stacking package in a manufacturing process according to an embodiment of this application;
FIG. 11b is a schematic diagram of a structure of a chip stacking package in a manufacturing process according to an embodiment of this application;
FIG. 11c is a schematic diagram of a structure of a chip stacking package in a manufacturing process according to an embodiment of this application;
FIG. 11d is a schematic diagram of a structure of a chip stacking package in a manufacturing process according to an embodiment of this application;
FIG. 11e is a schematic diagram of a structure of a chip stacking package in a manufacturing process according to an embodiment of this application;
FIG. 11f is a schematic diagram of a structure of a chip stacking package in a manufacturing process according to an embodiment of this application;
FIG. 11g is a schematic diagram of a structure of a chip stacking package in a manufacturing process according to an embodiment of this application;
FIG. 12a is a schematic diagram of a structure of a chip stacking package in a manufacturing process according to an embodiment of this application;
FIG. 12b is a schematic diagram of a structure of a chip stacking package in a manufacturing process according to an embodiment of this application;
FIG. 12c is a schematic diagram of a structure of a chip stacking package in a manufacturing process according to an embodiment of this application;
FIG. 13a is a schematic diagram of a structure of a chip stacking package in a manufacturing process according to an embodiment of this application;
FIG. 13b is a schematic diagram of a structure of a chip stacking package in a manufacturing process according to an embodiment of this application;
FIG. 13c is a schematic diagram of a structure of a chip stacking package in a manufacturing process according to an embodiment of this application;
FIG. 13d is a schematic diagram of a structure of a chip stacking package in a manufacturing process according to an embodiment of this application;
FIG. 13e is a schematic diagram of a structure of a chip stacking package in a manufacturing process according to an embodiment of this application;
FIG. 14a is a schematic diagram of a structure of a chip stacking package in a manufacturing process according to an embodiment of this application;
FIG. 14b is a schematic diagram of a structure of a chip stacking package in a manufacturing process according to an embodiment of this application;
FIG. 15a is a schematic diagram of a structure of a chip stacking package in a manufacturing process according to an embodiment of this application;
FIG. 15b is a schematic diagram of a structure of a chip stacking package in a manufacturing process according to an embodiment of this application;
FIG. 16 is a schematic diagram of a structure of a chip stacking package according to an embodiment of this application;
FIG. 17 is a locally enlarged schematic diagram of FIG. 16;
FIG. 18 is a schematic diagram of a structure of a chip stacking package according to an embodiment of this application;
FIG. 19 is a locally enlarged schematic diagram of FIG. 18;
FIG. 20 is a schematic diagram of a structure of a chip stacking package according to an embodiment of this application; and
FIG. 21 is a locally enlarged schematic diagram of FIG. 20.

### DESCRIPTION OF EMBODIMENTS

Unless otherwise defined, a technical term or a scientific term used in this application should have a common meaning understood by persons skilled in the art. The terms "first", "second", "third", "fourth", and the like used in the specification and claims of this application do not indicate any order, quantity, or importance, but are merely used to distinguish between different components. Therefore, a feature limited by "first", "second", "third", or "fourth" may explicitly or implicitly include one or more features. In the description of embodiments of this application, unless otherwise stated, "a plurality of' means two or more than two. Directional terms such as "left", "right", "up", and "down" are defined with respect to a direction in which a chip stacking package is schematically placed in the accompanying drawings. It should be understood that these directional terms are relative concepts, and are used for description and clarification. These directional terms may change correspondingly based on a change of an orientation in which the chip stacking package is placed.

The following describes embodiments of this application with reference to the accompanying drawings in embodiments of this application. In the following description, reference is made to the accompanying drawings that form a part of this application and show specific aspects of embodiments of this application in an illustrative manner or in which specific aspects of embodiments of this application may be used. It should be understood that embodiments of this application may be used in another aspect, and may include a structural or logical change that is not described in the accompanying drawings. Therefore, the following detailed description should not be understood in a limiting sense, and the scope of this application is defined by the appended claims. In addition, it should be further understood that features of the various example embodiments and/or aspects described herein may be combined with each other, unless explicitly stated otherwise.

Some embodiments of this application provide a terminal device. The terminal device may be an electronic product such as a mobile phone, a tablet computer, a notebook computer, a vehicle-mounted computer, a smart watch, or a smart band. A specific form of the terminal device is not specially limited in this embodiment of this application.

The terminal device includes a chip stacking package, and the chip stacking package is connected to another related electronic device in the terminal device by using a connector. For example, the chip stacking package may be connected to a circuit board in the terminal device by using the connector.

FIG. 2 is a schematic diagram of a chip stacking package according to this application. A chip stacking package 01 includes a first routing structure 10 and a second routing structure 20 that are disposed opposite to each other, and two layers of chips that are disposed between the first routing structure 10 and the second routing structure 20 in a stacked manner. The two layers of chips include a first chip 101 located at a first layer and a second chip 102 located at a second layer. The first chip 101 is in contact with the first routing structure 10, and the second chip 102 is located between the first chip 101 and the second routing structure 20.

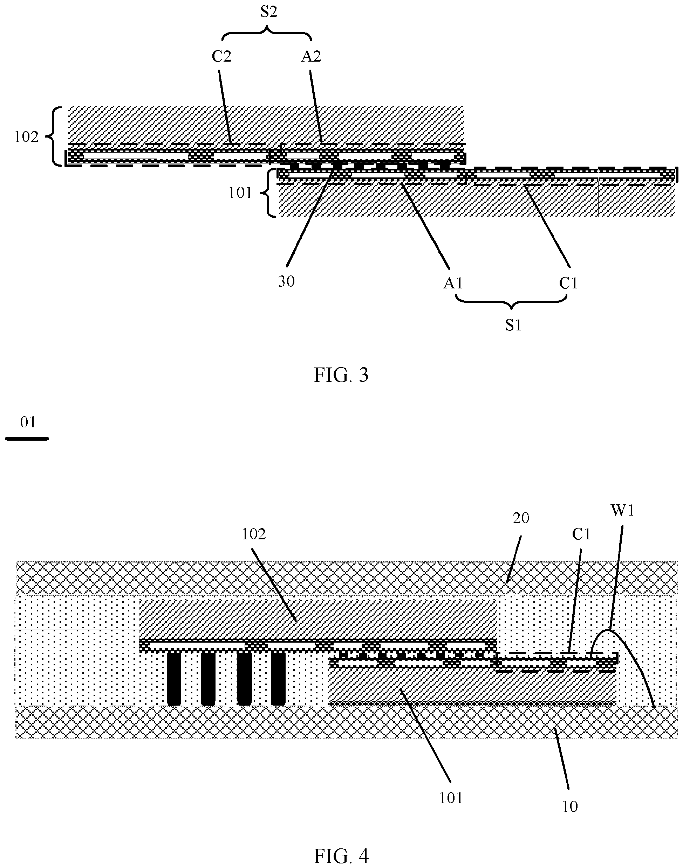

As shown in FIG. 3 (a locally enlarged schematic diagram of FIG. 2), an active surface S1 of the first chip 101 faces an active surface S2 of the second chip 102. In other words, the active surface S1 of the first chip 101 faces the second routing structure 20, and the active surface S2 of the second chip 102 faces the first routing structure 10.

As shown in FIG. 3, an active surface S1 of a first chip 101 includes a first overlapping region A1 and a first non-overlapping region C1, and an active surface S2 of a second chip 102 includes a second overlapping region A2 and a second non-overlapping region C2.

The first overlapping region A1 on the active surface S1 of the first chip 101 overlaps the second overlapping region A2 on the active surface S2 of the second chip 102. In addition, the first overlapping region A1 on the active surface S1 of the first chip 101 is connected to the second overlapping region A2 on the active surface S2 of the second chip 102. In other words, the first chip 101 and the second chip 102 are interconnected and communicate with each other by using the first overlapping region A1 and the second overlapping region A2.

It should be noted herein that, that the first overlapping region A1 on the active surface S1 of the first chip 101 overlaps the second overlapping region A2 on the active surface S2 of the second chip 102 means that: An orthographic projection of the first overlapping region A1 of the first chip 101 on the first routing structure 10 overlaps an orthographic projection of the second overlapping region A2 of the second chip 102 on the first routing structure 10. Certainly, "overlapping" of the two mentioned in the following means that orthographic projections of the two on the first routing structure 10 overlap. In addition, "non-overlapping" of the two mentioned in the following means that the orthographic projections of the two on the first routing structure 10 do not overlap.

On this basis, for the first non-overlapping region C1 on the active surface S1 of the first chip 101, refer to FIG. 2 and FIG. 3. The first non-overlapping region C1 of the first chip 101 does not overlap the active surface S2 of the second chip 102. The first non-overlapping region C1 on the active surface S1 of the first chip 101 may be connected to the second routing structure 20, or may be connected to the first routing structure 10. Alternatively, the first non-overlapping region C1 on the active surface S1 of the first chip 101 may be connected to both of the first routing structure 10 and the second routing structure 20 (FIG. 2 is merely schematically described by using the first non-overlapping region C1 and the second routing structure 20 on the active surface S1 of the first chip 101 as an example).

For example, as shown in FIG. 2, the first non-overlapping region C1 and the second routing structure 20 may be interconnected by using a vertical interconnection structure 501. As shown in FIG. 4, the first non-overlapping region C1 and the first routing structure 10 may be interconnected by using a lead W1 in a wire bonding manner.

In some possible embodiments, as shown in FIG. 2, the first non-overlapping region C1 on the active surface S1 of the first chip 101 may be connected to the second routing structure 20 only by using the vertical interconnection structure 501. In some possible embodiments, as shown in FIG. 4, the first non-overlapping region C1 on the active surface S1 of the first chip 101 may be connected to the first routing structure 10 only by using wire bonding. In some possible embodiments, in the first non-overlapping region C1 of the active surface S1 of the first chip 101, some regions are connected to the second routing structure 20 by using the vertical interconnection structure 501, and some regions are connected to the first routing structure 10 by using the lead W1 in the wire bonding manner.

In addition, for the second non-overlapping region C2 on the active surface S2 of the second chip 102, refer to FIG. 2 and FIG. 3. The second non-overlapping region C2 of the second chip 102 does not overlap the active surface S1 of the first chip 101. The second non-overlapping region C2 on the active surface S2 of the second chip 102 is connected to the first routing structure 10. For example, in some embodiments, the second non-overlapping region C2 and the first routing structure 10 may be connected by using a vertical interconnection structure 502.

In conclusion, compared with a current technology in which a through silicon via technology needs to be used to meet a power supply requirement, in the chip stacking package 01 in this embodiment of this application, the active surface of the first chip 101 is disposed to face the active surface of the second chip 102, and the first overlapping region A1 on the active surface S1 of the first chip 101 and the second overlapping region A2 on the active surface S2 of the second chip 102 are overlapped and connected. In addition, it is further disposed that the second non-overlapping region C2 of the second chip 102 does not overlap the active surface S1 of the first chip 101, and the first non-overlapping region C1 of the first chip 101 does not overlap the active surface S2 of the second chip 102. In other words, the first chip 101 does not completely block the active surface of the second chip 102, and the second chip 102 does not completely block the active surface of the first chip 101. This ensures that the first non-overlapping region C1 of the first chip 101 can be connected to the first routing structure 10 to supply power without using a through silicon via, the second non-overlapping region C2 of the second chip 102 can be connected to the first routing structure 10 to supply power without using the through silicon via. In other words, the chip stacking package in this application can meet power supply requirements of two chips. This avoids a problem of high process costs caused by using the through silicon via technology.

In addition, compared with the current technology, because the chip stacking package 01 in this application does not need to use the through silicon via technology, there is no need to reserve enough space inside a chip. This reduces an area of the chip, stress on the chip, and a risk of warpage of the chip.

As shown in FIG. 3, in this application, for a connection manner of the first overlapping region A1 on the active surface S1 of the first chip 101 and the second overlapping region A2 on the active surface S2 of the second chip 102, the first overlapping region A1 of the first chip 101 may be connected to the second overlapping region A2 of the second chip 102 by using a direct interconnection structure 30. In a direction perpendicular to the first chip 101 and the second chip 102, the direct interconnection structure 30 extends from the first overlapping region A1 to the second overlapping region A2, that is, the direct interconnection structure 30 extends from the second overlapping region A2 to the first overlapping region A1. In other words, the direct interconnection structure 30 is used as a shortest interconnection structure (namely, a shortest interconnection path) between the first overlapping region A1 of the first chip 101 and the second overlapping region A2 of the second chip 102. This effectively ensures a high communications rate between the first chip 101 and the second chip 102. Especially, compared with an existing fan out wafer level package (FOWLP) technology in which two layers of chips are interconnected by using a long cable in a redistribution layer, the chip stacking package 01 in this application implements a shortest interconnection path between the first chip 101 and the second chip 102 by using the direct interconnection structure 30. This greatly improves a communications rate between chips.

On this basis, for the direct interconnection structure 30:

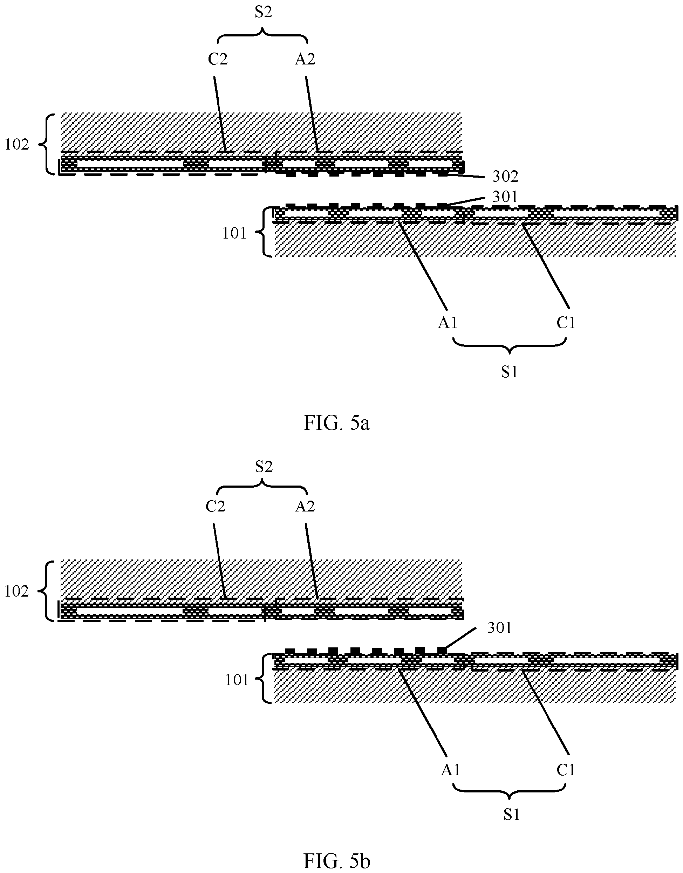

In some possible embodiments, as shown in FIG. 5a, the direct interconnection structure 30 may include a first micro-bump 301 located in the first overlapping region A1 and a second micro-bump 302 that is connected to the first micro-bump 301 by using solder and that is disposed in the second overlapping region A2. A connection manner of the first micro-bump 301 and the second micro-bump 302 may include thermal compression bonding or reflow. The first micro-bump 301 and the second micro-bump 302 may be one or a combination of an embedded micro-bump and a non-embedded micro-bump.

In some possible embodiments, as shown in FIG. 5b, the direct interconnection structure 30 may include a first micro-bump 301 located in the first overlapping region A1 and a solder pad (not shown in FIG. 5b) that is connected to the first micro-bump 301 by using solder and that is disposed in the second overlapping region A2. A connection manner of the first micro-bump 301 and the solder padmay include thermal compression bonding or reflow. The first micro-bump 301 may be one or a combination of an embedded micro-bump (embedded µbump) and a non-embedded micro-bump.

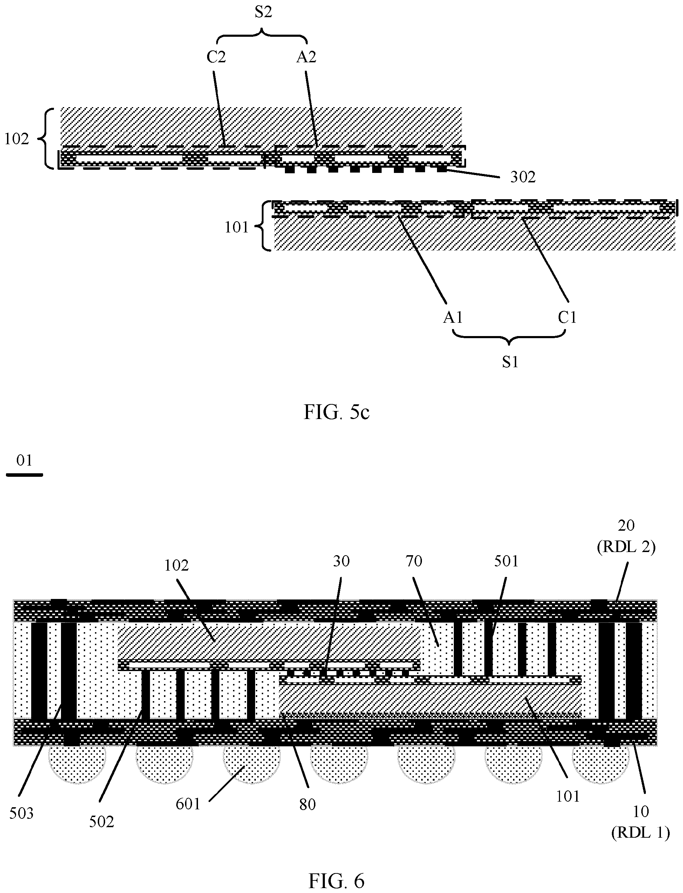

In some possible embodiments, as shown in FIG. 5c, the direct interconnection structure 30 may include a second micro-bump 302 located in the second overlapping region A2 and a solder pad (not shown in FIG. 5c) that is connected to the second micro-bump 302 by using solder and that is disposed on the active surface S1 of the first chip 101 in the first overlapping region A1. A connection manner of the second micro-bump 302 and the solder padmay include thermal compression bonding or reflow. The second micro-bump 302 may be one or a combination of an embedded micro-bump (embedded µbump) and a non-embedded micro-bump.

In some possible embodiments, the direct interconnection structure 30 may include a first solder pad disposed in the first overlapping region A1 and a second solder pad that is connected to the first solder pad and that is disposed in the second overlapping region A2. A connection manner of the first solder pad and the second solder pad includes hybrid bonding (hybrid bonding, HB), surface activated bonding (SAB), or atomic diffusion bonding (ADB).

As shown in FIG. 6, in some embodiments, a first routing structure 10 and a second routing structure 20 in the chip stacking package 01 may be interconnected by using a vertical interconnection structure 503 located on a periphery of a first chip 101 and a second chip 102, to ensure interconnection and communication between the first routing structure 10 and the second routing structure 20.

In this application, a specific disposing form of the foregoing vertical interconnection structure is not limited. For example, a vertical interconnection structure 501 between a first non-overlapping region C1 and the second routing structure 20 on an active surface S1 of the first chip 101, a vertical interconnection structure 502 between a second non-overlapping region C2 and the first routing structure 10 on an active surface S2 of the second chip 102, and the vertical interconnection structure 503 between the first routing structure 10 and the second routing structure 20.

The vertical interconnection structures 501, 502, and 503 may be one or a combination of a micro-bump (µbump), a copper pillar (Cu Pillar, Cu stud), a solder ball, and a controlled collapse chip connection structure (C4).

In addition, in some embodiments, as shown in FIG. 6, a connector 601 may be disposed on a lower surface of the first routing structure 10 in the chip stacking package 01, and the chip stacking package 01 is connected to another electronic device by using the connector 601. The connector 601 may be one or a combination of a micro-bump (µbump), a copper column (Cu Pillar), or a controlled collapse chip connection structure (C4). For example, the connector 601 shown in FIG. 6 may be a solder ball.

In some embodiments, the chip stacking package 01 may be directly connected to a printed circuit board (PCB) in a terminal device by using the connector 601 (for example, a solder ball) disposed on a lower surface of the first routing structure 10.

In some embodiments, the chip stacking package 01 may be connected to a substrate or another package structure by using the connector 601 (for example, a solder ball) disposed on a lower surface of the first routing structure 10. For example, in some possible embodiments, the chip stacking package 01 may be connected to another chip stacking package 01 by using the connector 601 (for example, a solder ball) disposed on a lower surface of the first routing structure 10.

In some embodiments, as shown in FIG. 6, the chip stacking package 01 is a mold compound 70 between the first routing structure 10 and the second routing structure 20, and a region between the first routing structure 10 and the second routing structure 20 is molded (molding) by using the mold compound 70. In this way, the first chip 101, the second chip 102, the direct interconnection structure 30, the vertical interconnection structure (501, 502, 503), and the like are embedded in the mold compound 70. The mold compound 70 may use an epoxy molding compound (EMC), but this is not limited thereto.

In addition, for the first routing structure 10 and the second routing structure 20 in the chip stacking package 01:
In some embodiments, as shown in FIG. 6, the first routing structure 10 may use a redistribution layer (namely, a first redistribution layer RDL 1). It may be understood that the redistribution layer is formed by alternately stacking a conducting layer and a dielectric layer.

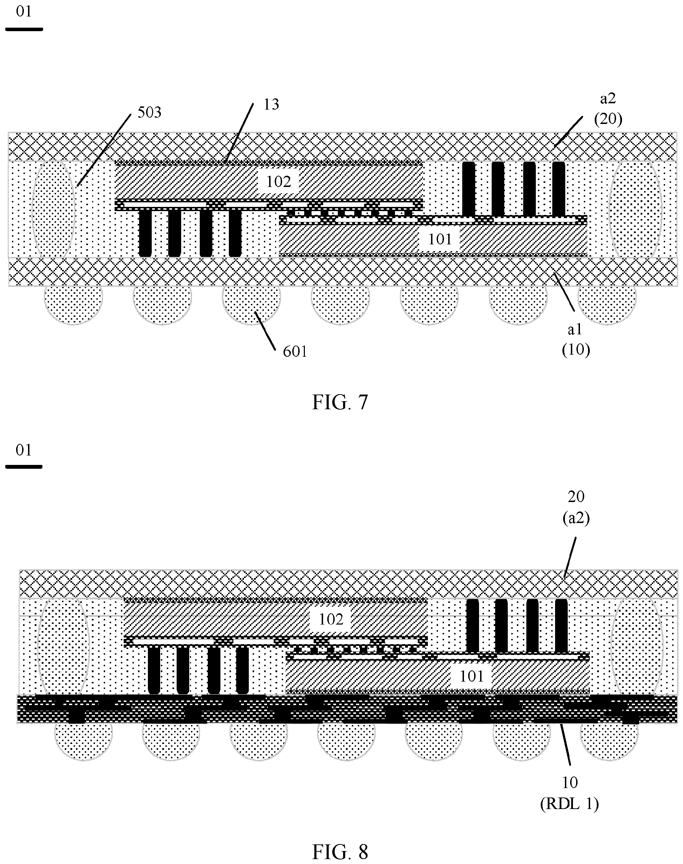

In some embodiments, as shown in FIG. 7, the first routing structure 10 may use a substrate (namely, a first cabling substrate a1) on which a cabling pattern is disposed. It may be understood that the substrate on which the cabling pattern is disposed includes: a base (base) and a conducting layer and a dielectric layer that are formed on the base (base) and that are alternately disposed.

In some embodiments, as shown in FIG. 6, the second routing structure 20 may use a redistribution layer (namely, a second redistribution layer RDL 2).

In some embodiments, as shown in FIG. 7, the second routing structure 20 may use a substrate (namely, a second cabling substrate a2) on which a cabling pattern is disposed.

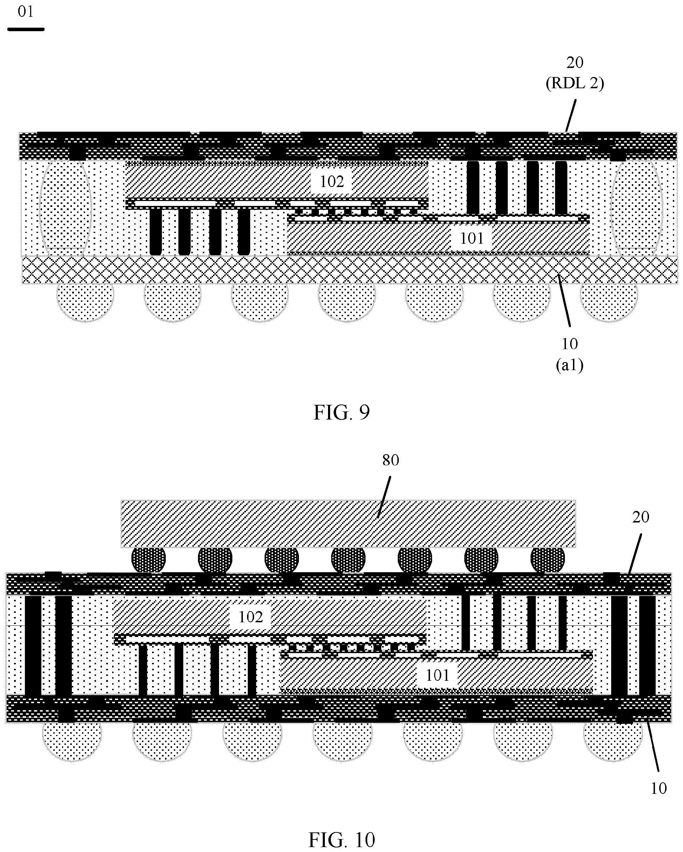

For example, in some possible embodiments, as shown in FIG. 6, in the chip stacking package 01, both of the first routing structure 10 and the second routing structure 20 use redistribution layers (RDL 1 and RDL 2). In some possible embodiments, as shown in FIG. 7, in the chip stacking package 01, both of the first routing structure 10 and the second routing structure 20 use substrates (a1 and a2) on which cabling patterns are disposed. In some possible embodiments, as shown in FIG. 8, in the chip stacking package 01, the first routing structure 10 uses a redistribution layer (RDL 1), and the second routing structure 20 uses a substrate (a2) on which a cabling pattern is disposed. In some possible embodiments, as shown in FIG. 9, in the chip stacking package 01, the first routing structure 10 uses a substrate (a1) on which a cabling pattern is disposed, and the second routing structure 20 uses a redistribution layer (RDL 2).

In addition, the chip stacking package 01 provided in this embodiment of this application has a good integration level.

In some embodiments, the chip stacking package 01 may be integrated into a currently mature package on package (POP). For example, in some possible embodiments, the chip stacking package 01 may be integrated into a fan out wafer level package (FOPOP). In some possible embodiments, the chip stacking package 01 may be integrated into a high bandwidth package on package (HBPOP).

In some embodiments, as shown in FIG. 10, a package body 80 may be disposed (integrated) on the second routing structure 20 of the chip stacking package 01. In other words, the package body 80 is connected to the second routing structure 20 by using a connector. For example, a package body may be a memory package body including a memory chip, but this is not limited thereto.

In some possible embodiments, a double data rate (DDR) synchronous dynamic random access memory package may be integrated in the second routing structure 20.

On this basis, the following further describes the chip stacking package 01 in this application by using specific embodiments.

### Embodiment 1

In this embodiment, a chip stacking package 01 shown in FIG. 6 is used as an example to describe a manufacturing process of the chip stacking package 01.

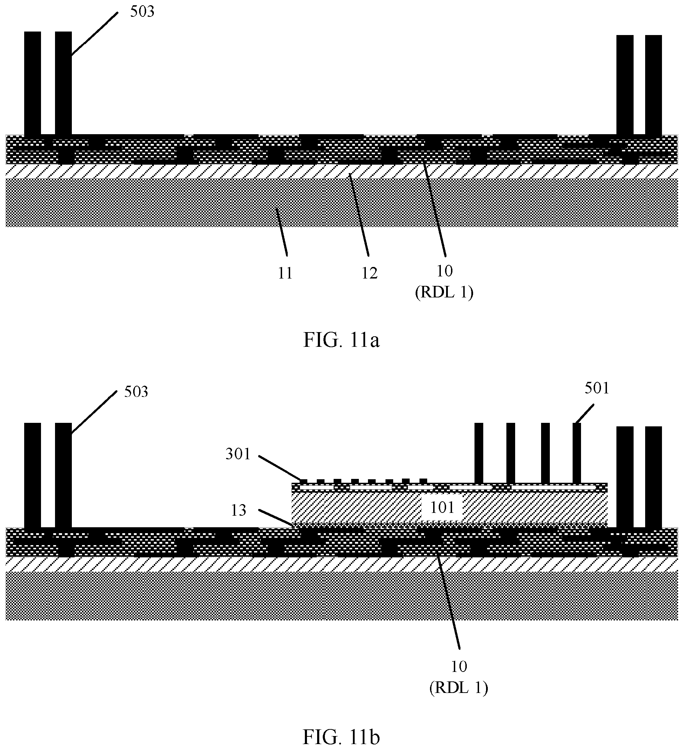

First, as shown in FIG. 11a, a temporary bonding layer 12, the first redistribution layer RDL 1 (namely, the first routing structure 10), and the vertical interconnection structure 503 are sequentially formed on a carrier 11.

The carrier 11 may be a glass sheet, a silicon sheet, a ceramic sheet, or another sheet that has a similar function and is compatible with a wafer level package processing material. The temporary bonding layer 12 may be a thin film formed by using ultra-violet (UV) adhesive, a light-to-heat conversion (LTHC) material, or the like, to facilitate subsequent debonding. The vertical interconnection structure 503 may be a copper column, an aluminum column, a solder ball, or another equivalent electrical interconnection structure. In this embodiment, that the vertical interconnection structure 503 is a copper column is taken as an example for description.

Then, as shown in FIG. 11b, a back surface (namely, a non-active surface) of a first chip 101 is attached to the first redistribution layer RDL 1 by using a die attach film (DAF) 13. Before attachment, on the active surface S1 of the first chip 101, the first micro-bump 301 is formed in the first overlapping region A1, and the vertical interconnection structure 501 (for example, a copper column) is formed in the first non-overlapping region C1.

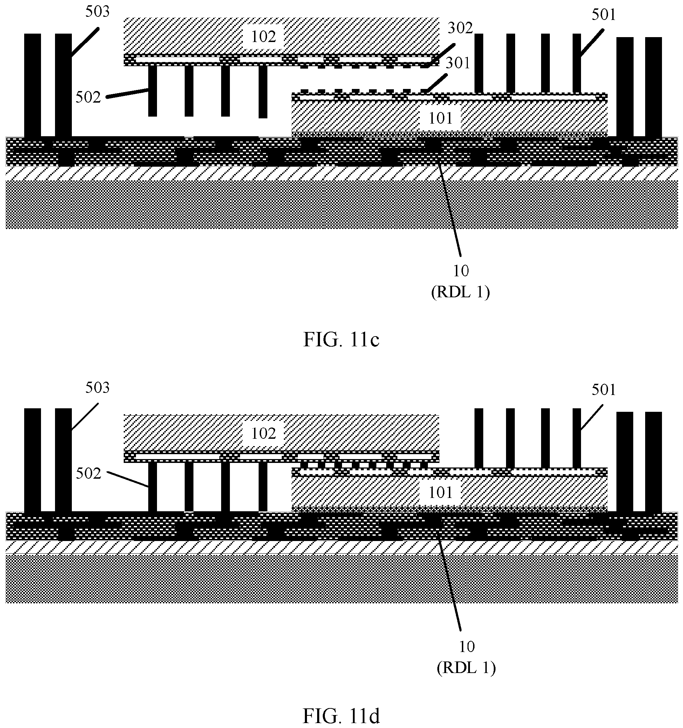

Then, as shown in FIG. 11c, the active surface S2 of the second chip 102 faces downward and is bonded to the first chip 101. Before being bonded, on the active surface S2 of the second chip 102, the second micro-bump 302 is disposed in the second overlapping region A2, and the vertical interconnection structure 502 (for example, a copper column disposed with solder on the top) is formed in the second non-overlapping region C2. After the first chip 101 and the second chip 102 are bonded, as shown in FIG. 11d, the first micro-bump 301 in the first overlapping region A1 of the first chip 101 is connected to the second micro-bump 302 in the second overlapping region A2 of the second chip 102, and the vertical interconnection structure 502 in the second non-overlapping region C2 of the second chip 102 is connected to a solder pad on the first redistribution layer RDL 1. The first chip 101 and the second chip 102 may be interconnected in a thermal compression bonding (TCB) or reflow (mass reflow) manner, and the first micro-bump 301 in the first overlapping region A1 and the second micro-bump 302 in the second overlapping region A2 form the direct interconnection structure 30.

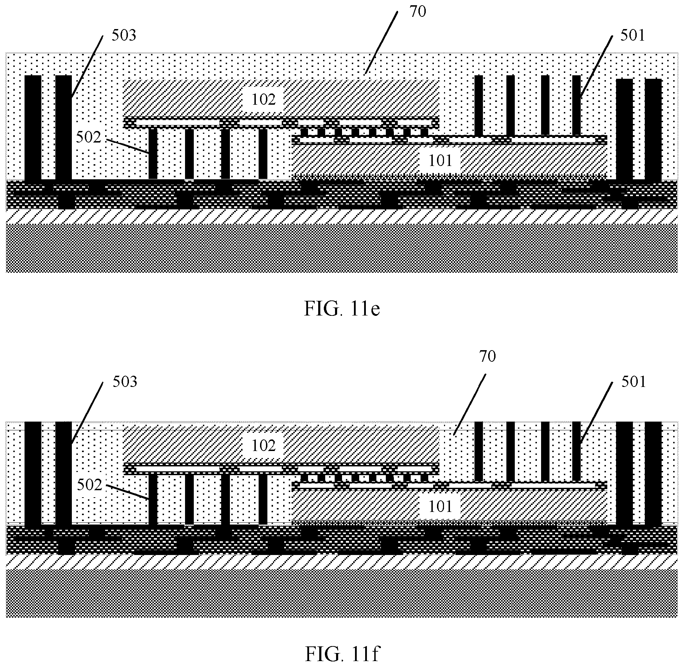

Then, as shown in FIG. 11e, an entire package body is molded (molding) by using the mold compound 70. The mold compound includes but is not limited to an epoxy molding compound (EMC), and a thickness of the mold compound 70 may be adjusted based on a thickness of the package body, to ensure that the first chip 101, the second chip 102, the vertical interconnection structures 501, 503, and the like are all embedded in the mold compound 70.

Then, as shown in FIG. 11f, a grinding method is used to thin the mold compound 70 to a proper thickness to expose the vertical interconnection structures 501 and 503.

It should be noted herein that, in an actual manufacturing process, it may be ensured that an upper surface of the vertical interconnection structure 501 is flush with an upper surface of the vertical interconnection structure 503 by adjusting a process parameter. Certainly, after the mold compound 70 is ground, an upper surface of the second chip 102 may be exposed, or an upper surface of the second chip 102 may not be exposed. This is not specifically limited in this application, and may be designed based on a requirement in practice. FIG. 11f is described merely by using an example in which the mold compound 70 is not exposed on the upper surface of the second chip 102.

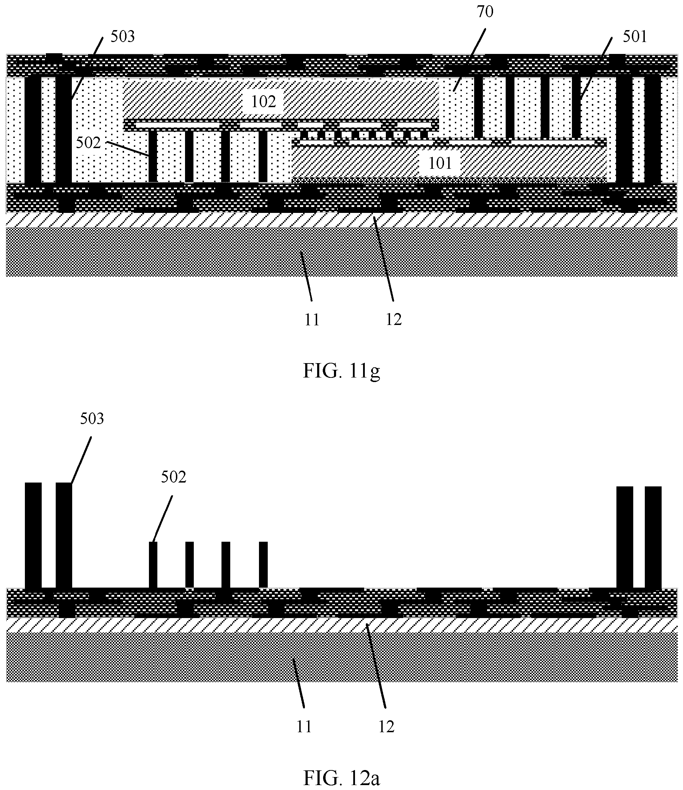

Then, as shown in FIG. 11g, the second redistribution layer RDL 2 (namely, the second routing structure 20) is manufactured on the mold compound 70 that is thinned by using the foregoing grinding process. The second redistribution layer RDL 2 is connected to upper surfaces of the vertical interconnection structures 501 and 503 by using a solder pad.

Then, the temporary bonding layer 12 is debonded to remove the carrier 11 at the bottom. Then, the connector 601 (for example, a solder ball) is manufactured at a bottom of the first redistribution layer RDL 1, and finally the connector 601 is scribed into a single package particle, to obtain the chip stacking package 01 shown in FIG. 6.

### Embodiment 2

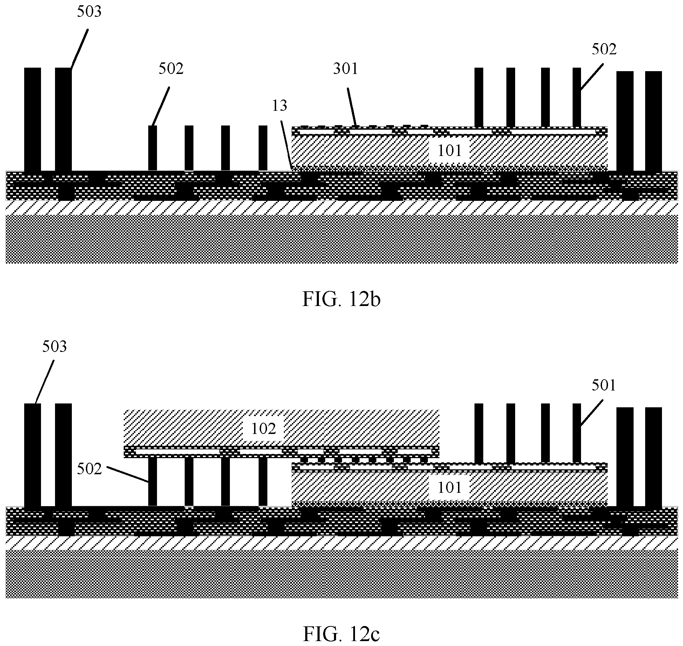

In another optional manufacturing manner, compared with Embodiment 1, a difference in this embodiment lies in that, as shown in FIG. 12a, before the first chip 101 is attached, the vertical interconnection structure 502 is directly manufactured on the first redistribution layer RDL 1. Then, as shown in FIG. 12b, a back surface (a non-active surface) of the first chip 101 is attached to the first redistribution layer RDL 1 by using a chip bonding layer 13. An upper surface of the vertical interconnection structure 502 is flush with an upper surface of the first micro-bump 301 in the first overlapping region A1 of the first chip 101.

Then, as shown in FIG. 12c, the active surface S2 of the second chip 102 faces downward and is bonded to the vertical interconnection structure 502 and the upper surface of the first micro-bump 301. Because the vertical interconnection structure 502 and the upper surface of the first micro-bump 301 are in a same plane, that is, the second chip 102 and the first chip 101 are bonded in a same plane. This greatly reduces bonding difficulty.

### Embodiment 3

In this embodiment, a chip stacking package 01 shown in FIG. 7 is used as an example to describe a manufacturing process of the chip stacking package 01.

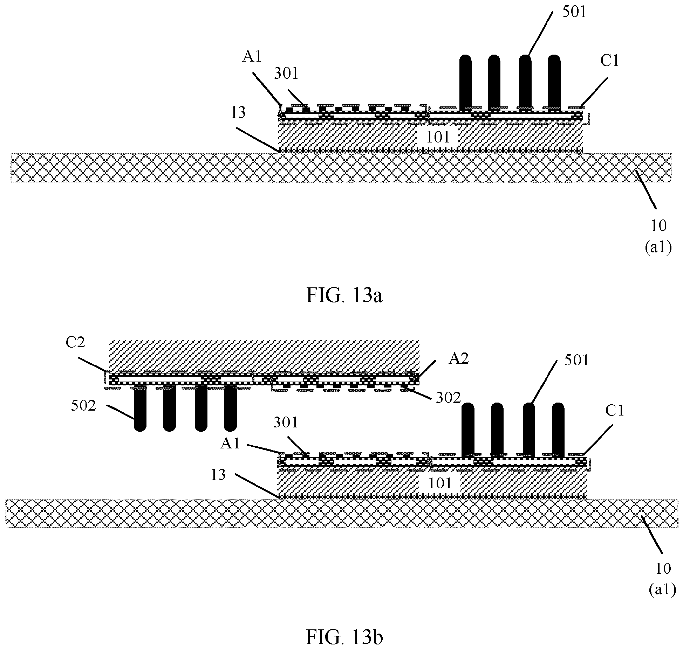

First, as shown in FIG. 13a, a back surface (a non-active surface) of the first chip 101 is attached to the first cabling substrate a1 (namely, the first routing structure 10) by using a chip bonding layer 13. Before attachment, on the active surface S1 of the first chip 101, the first micro-bump 301 is formed in the first overlapping region A1, and the vertical interconnection structure 501 is formed in the first non-overlapping region C1. For example, the vertical interconnection structure 501 may be a copper column provided with solder (a solder cap) on the top.

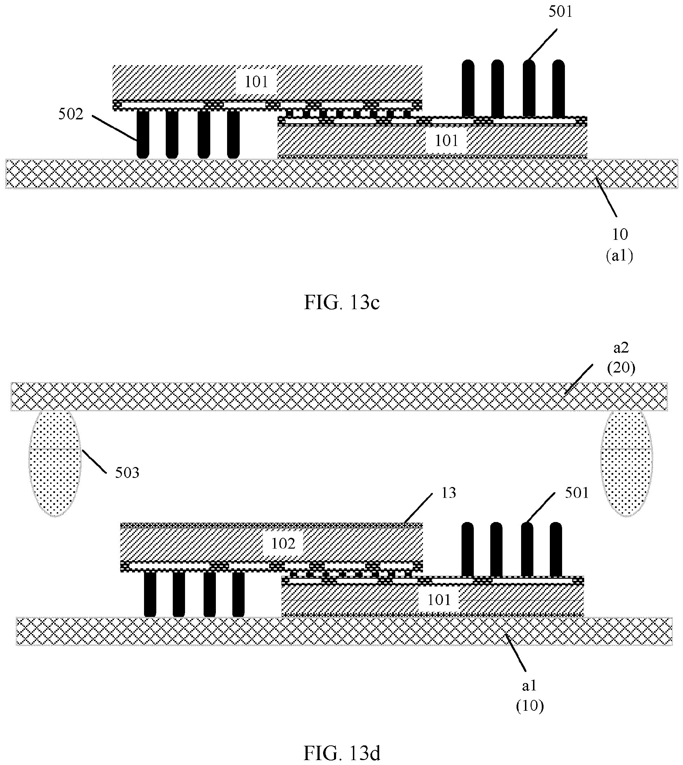

Then, as shown in FIG. 13b and FIG. 13c, the active surface S2 of the second chip 102 faces downward and is bonded to the first chip 101. Before being bonded, on the active surface S2 of the second chip 102, the second micro-bump 302 is formed in the second overlapping region A2, and the vertical interconnection structure 502 (for example, a copper column disposed with solder on the top) is formed in the second non-overlapping region C2. Therefore, after the first chip 101 and the second chip 102 are bonded, the first micro-bump 301 in the first overlapping region A1 of the first chip 101 is connected to the second micro-bump 302 in the second overlapping region A2 of the second chip 102, and the vertical interconnection structure 502 in the second non-overlapping region C2 of the second chip 102 is connected to a solder pad on the first cabling substrate a1.

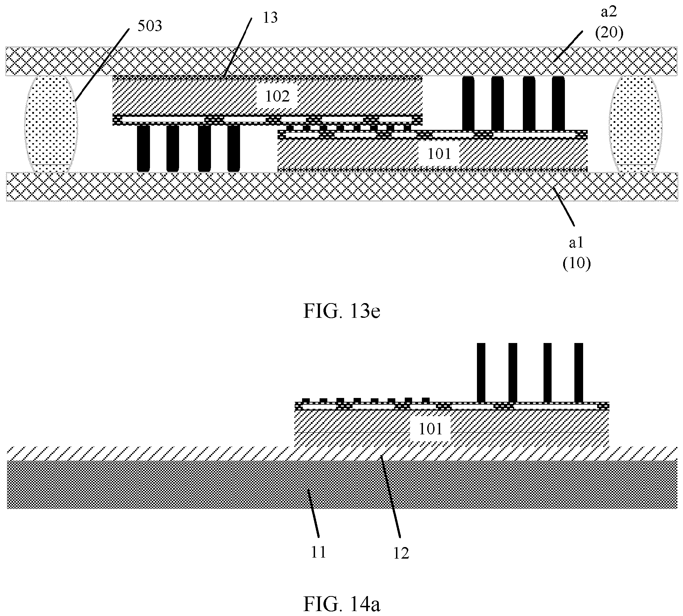

Then, as shown in FIG. 13d and FIG. 13e, a solder ball (namely, the vertical interconnection structure 503) is placed on the second cabling substrate a2 (namely, the second routing structure 20) in a solder ball attach manner, then a side of the second cabling substrate a2 on which the solder ball is formed faces downward and is mounted on the second chip 102, and the second cabling substrate a2 is bonded to an upper surface (namely, a non-active surface) of the second chip 102 by using the chip bonding layer 13. In this case, the second cabling substrate a2 is connected to an upper surface of the vertical interconnection structure 501, and the solder ball (namely, the vertical interconnection structure 503) is connected to the first cabling substrate a1.

The solder ball used in the vertical interconnection structure 503 may be a solder ball of a shell-core structure. The solder ball of the shell-core structure may be a copper-core solder ball (Cu-core solder ball, CCSB), a plastic-core solder ball, or the like.

In addition, for the chip bonding layer 13 between the second cabling substrate a2 and the upper surface of the second chip 102, in a manufacturing process, as shown in FIG. 13d, the chip bonding layer 13 may be first attached to the upper surface of the second chip 102, and then the second cabling substrate a2 is mounted. Alternatively, the chip bonding layer 13 may be first attached to a position, corresponding to the second chip 102, on the second cabling substrate a2, and then the second cabling substrate a2 is mounted. This is not specifically limited in this application, and may be disposed based on a requirement in practice.

Then, an entire package body is molded (molding) by using the mold compound 70. For example, the package body may be molded in an injection and molding manner. Then, the connector 601 (for example, a solder ball) is manufactured at a bottom of the first cabling substrate a1, and finally, the connector 601 is scribed into a single package particle, to obtain the chip stacking package 01 shown in FIG. 7.

### Embodiment 4

This embodiment provides the chip stacking package 01, where the first chip 101 is disposed in the first routing structure 10 in an embedded manner, to reduce a thickness of the chip stacking package 01.

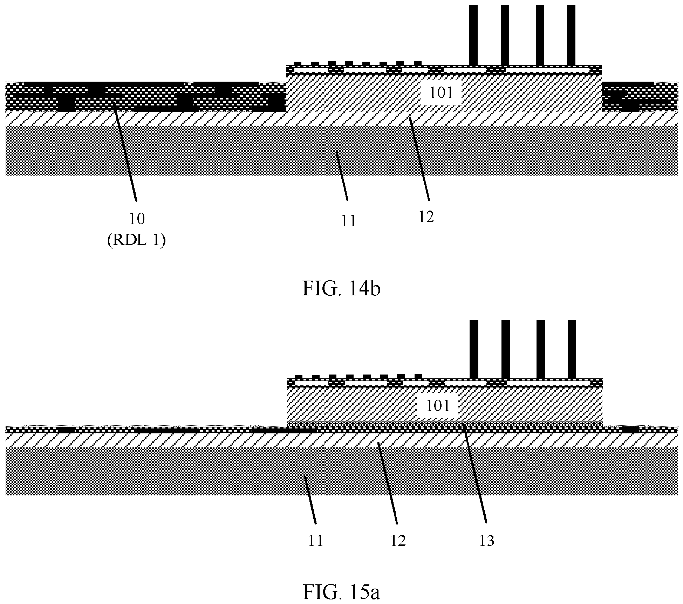

In an embedded manner that can be implemented, as shown in FIG. 14b, the first chip 101 may penetrate the first routing structure 10 and be embedded in the first routing structure 10.

An example in which the first routing structure 10 is the first redistribution layer RDL 1 is used. For the chip stacking package 01 in which the first chip 101 penetrates the first redistribution layer RDL 1 and is embedded in the first redistribution layer RDL 1, in an actual manufacturing process, refer to FIG. 14a and FIG. 14b. After a temporary bonding layer 12 is formed on the carrier 11, a back surface (a non-active surface) of the first chip 101 is attached to the temporary bonding layer 12, and then the first redistribution layer RDL 1 is formed, to embed the first chip 101 in the first redistribution layer RDL 1.

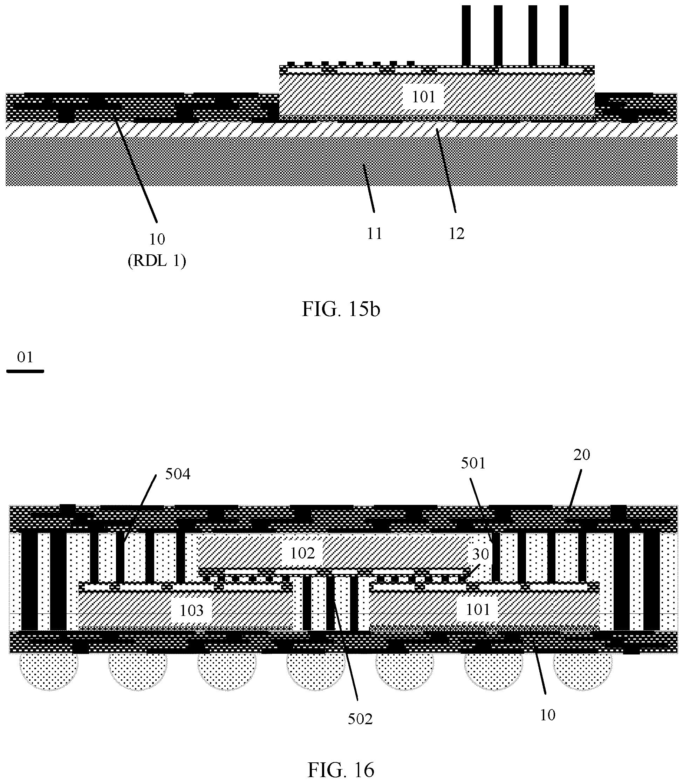

In another embedded manner that can be implemented, as shown in FIG. 15b, the first chip 101 may be embedded in the first routing structure 10 without penetrating the first routing structure 10.

An example in which the first routing structure 10 is the first redistribution layer RDL 1 is used. For the chip stacking package 01 in which the first chip 101 does not penetrate the first redistribution layer RDL 1 and is embedded in the first redistribution layer RDL 1, in an actual manufacturing process, refer to FIG. 15a and FIG. 15b. After a temporary bonding layer 12 is formed on the carrier 11, a partial cabling layer (for example, one or two conducting layers and dielectric layers are alternately disposed) in the first redistribution layer RDL 1 may be formed on the temporary bonding layer 12. Then, the first chip 101 is attached to an upper surface of the partial cabling layer by using a chip bonding layer 13. Then, a remaining cabling layer of the first redistribution layer RDL 1 is formed, to embed the first chip 101 in the first redistribution layer RDL 1.

### Embodiment 5

As shown in FIG. 16, this embodiment provides the chip stacking package 01. In addition that the chip stacking package 01 includes the first chip 101 and the second chip 102, the chip stacking package 01 further includes a third chip 103 disposed at a same layer as the first chip 101, that is, an overlapping part does not exist between the first chip 101 and the third chip 103.

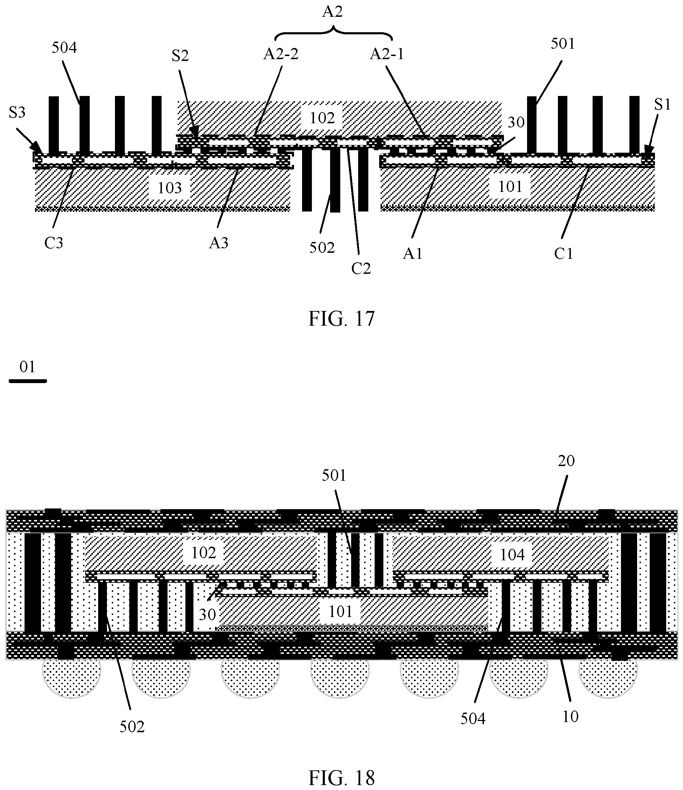

As shown in FIG. 17 (a locally enlarged schematic diagram of FIG. 16), an active surface S3 of the third chip 103 faces the active surface S2 of the second chip 102, that is, the active surface S3 of the third chip 103 faces a same direction as the active surface S1 of the first chip 101. The active surface S3 of the third chip 103 includes a third overlapping region A3 and a third non-overlapping region C3.

In the chip stacking package 01, as shown in FIG. 17, the second overlapping region A2 on the active surface S2 of the second chip 102 includes: a first partial region A2-1 that overlaps the first overlapping region A1 of the first chip 101 and a second partial region A2-2 that overlaps the third overlapping region A3 of the third chip 103. The first partial region A2-1 is connected to the first overlapping region A1 of the first chip 101 by using the direct interconnection structure 30, and the second partial region A2-2 is connected to the third overlapping region A3 of the third chip 103 by using the direct interconnection structure 30.

Refer to FIG. 16 and FIG. 17. The first non-overlapping region C1 of the first chip 101 does not overlap the active surface S2 of the second chip 102, and the first non-overlapping region C1 of the first chip 101 is connected to the second routing structure 20 by using the vertical interconnection structure 501. Certainly, the first non-overlapping region C1 of the first chip 101 may also be connected to the first routing structure 10 in a wire bonding manner. Alternatively, in the first non-overlapping region C1 of the first chip 101, a part of regions are connected to the first routing structure 10 by using a vertical interconnection structure and a part of regions are connected to the first routing structure 10 in the wire bonding manner.

Refer to FIG. 16 and FIG. 17. The second non-overlapping region C2 of the second chip 102 does not overlap either the active surface S1 of the first chip 101 or the active surface S3 of the third chip 103, and the second non-overlapping region C2 of the second chip 102 is connected to the first routing structure 10 by using the vertical interconnection structure 502.

Refer to FIG. 16 and FIG. 17. The third non-overlapping region C3 of the third chip 103 does not overlap the active surface S2 of the second chip 102, and the third non-overlapping region C3 of the third chip 103 is connected to the second routing structure 20 by using a vertical interconnection structure 504. Certainly, the third non-overlapping region C3 of the third chip 103 may also be connected to the first routing structure 10 in the wire bonding manner. Alternatively, in the third non-overlapping region C3 of the third chip 103, a part of regions are connected to the first routing structure 10 by using the vertical interconnection structure 504 and a part of regions are connected to the first routing structure 10 in the wire bonding manner.

In addition, to reduce a thickness of the chip stacking package 01, both of the first chip 101 and the third chip 103 may be embedded in the first routing structure 10. For an embedded manner of the first chip 101 and the third chip 103, refer to the foregoing Embodiment 4.

Embedded depths of the first chip 101 and the third chip 103 in the first routing structure 10 may be the same or different. For example, both of the first chip 101 and the third chip 103 may penetrate the first routing structure 10 and be embedded in the first routing structure 10. For another example, the first chip 101 penetrates the first routing structure 10 and is embedded in the first routing structure 10, and the third chip 103 is embedded in the first routing structure 10 without penetrating the first routing structure 10.

In some possible embodiments, to simplify a manufacturing process, it may be disposed that the embedded depths of the first chip 101 and the third chip 103 in the first routing structure 10 are the same, so that the first chip 101 and the third chip 103 are embedded in the first routing structure 10 by using a same embedding process.

### Embodiment 6

As shown in FIG. 18, this embodiment provides the chip stacking package 01. In addition that the chip stacking package 01 includes the first chip 101 and the second chip 102, the chip stacking package 01 further includes a fourth chip 104 disposed at a same layer as the second chip 102, that is, an overlapping part does not exist between the second chip 102 and the fourth chip 104.

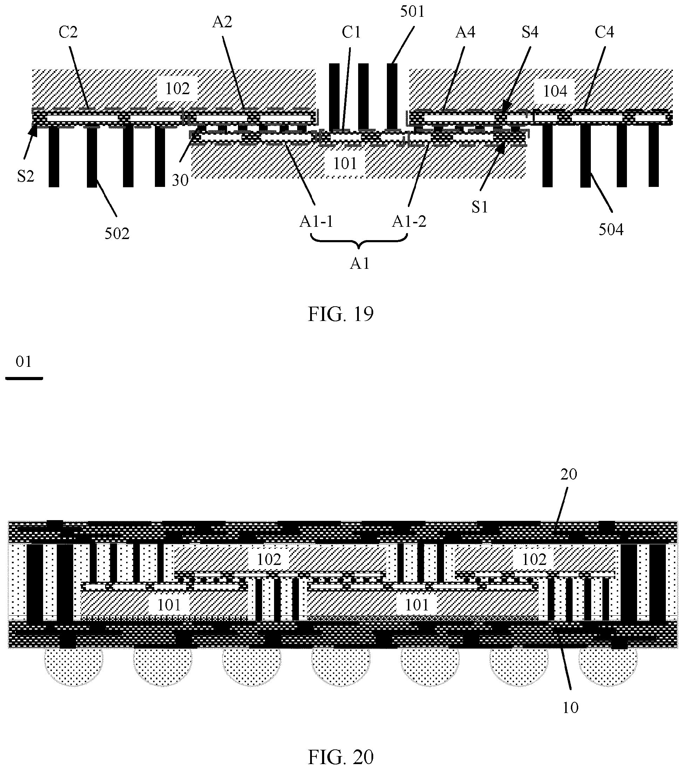

As shown in FIG. 19 (a locally enlarged schematic diagram of FIG. 18), an active surface S4 of the fourth chip 104 faces the active surface S1 of the first chip 101, that is, the active surface S4 of the fourth chip 104 faces a same direction as the active surface S2 of the second chip 102. The active surface S4 of the fourth chip 104 includes a fourth overlapping region A4 and a fourth non-overlapping region C4.

In the chip stacking package 01, as shown in FIG. 19, the first overlapping region A1 on the active surface S1 of the first chip 101 includes: a first partial region A1-1 that overlaps the second overlapping region A2 of the second chip 102 and a second partial region A1-2 that overlaps the fourth overlapping region A4 of the fourth chip 104. The first partial region A1-1 is connected to the second overlapping region A2 of the second chip 102 by using the direct interconnection structure 30, and the second partial region A1-2 is connected to the fourth overlapping region A4 of the fourth chip 104 by using the direct interconnection structure 30.

Refer to FIG. 18 and FIG. 19. The first non-overlapping region C1 of the first chip 101 does not overlap either the active surface S2 of the second chip 102 or the active surface S4 of the fourth chip 104, and the first chip 101 is connected to the second routing structure 20 in the first non-overlapping region C1 by using the vertical interconnection structure 501.

Refer to FIG. 18 and FIG. 19. The first non-overlapping region C2 of the second chip 102 does not overlap the active surface S2 of the first chip 101, and the second chip 102 is connected to the first routing structure 10 in the first non-overlapping region C2 by using the vertical interconnection structure 502.

Refer to FIG. 18 and FIG. 19. The fourth non-overlapping region C4 of the fourth chip 104 does not overlap the active surface S1 of the first chip 101, and the fourth chip 104 is connected to the first routing structure 10 in the fourth non-overlapping region C4 by using a vertical interconnection structure 504.

### Embodiment 7

FIG. 20 is a schematic diagram of a structure of a chip stacking package 01 according to an embodiment. The chip stacking package 01 includes: a plurality of first chips 101 (for example, 101-1 and 101-2 in FIG. 20) disposed at a same layer and a plurality of second chips 102 (for example, 102-1 and 102-2 in FIG. 20) disposed at a same layer. In addition, the plurality of first chips 101 and the plurality of second chips 102 are placed in a staggered manner. In FIG. 20, two first chips 101-1 and 101-2 and two second chips 102-1 and 102-2 are merely used as an example for description, but this application is not limited thereto. Alternatively, there may be three first chips 101, four second chips 102, and the like.

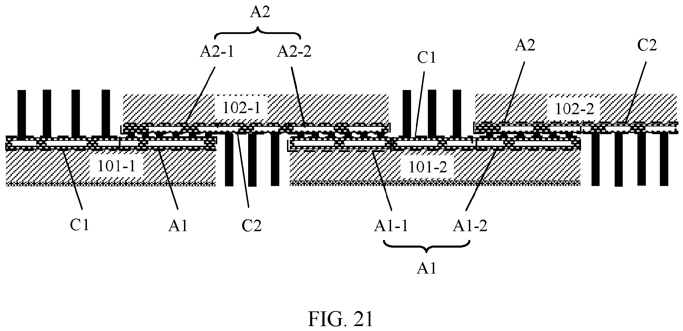

As shown in FIG. 21 (a locally enlarged schematic diagram of FIG. 20), for the two first chips 101-1 and 101-2:
The first overlapping region A1 of the first chip 101-1 and the first partial region A2-1 of the second overlapping region A2 of the second chip 102-1 are overlapped and connected by using the direct interconnection structure 30.

In the first overlapping region A1 of the first chip 101-2, a first partial region A1-1 and a second partial region A2-2 in the second overlapping region A2 of the second chip 102-1 are overlapped and connected by using the direct interconnection structure 30. A second partial region A1-2 and the second overlapping region A2 of the second chip 102-2 are overlapped and connected by using the direct interconnection structure 30.

The first non-overlapping region C1 of the first chip 101-1 does not overlap active surfaces of the second chips 102-1 and 102-2, and the first non-overlapping region C1 of the first chip 101-1 is connected to the second routing structure 20 by using a vertical interconnection structure. The first non-overlapping region C1 of the first chip 101-2 does not overlap the active surfaces of the second chips 102-1 and 102-2, and the first non-overlapping region C1 of the first chip 101-2 is connected to the second routing structure 20 by using the vertical interconnection structure.

In other words, in a case in which the plurality of the first chips 101 are disposed in the chip stacking package 01, the first overlapping region A1 of each first chip 101 and the second overlapping region A2 of the at least one second chip 102 are connected by using the direct interconnection structure 30. The first non-overlapping region C1 of each first chip 101 does not overlap active surfaces of all the second chips 102, and the first non-overlapping region C1 of each first chip 101 is connected to the second routing structure 20 by using the vertical interconnection structure.

As shown in FIG. 21 (a locally enlarged schematic diagram of FIG. 20), for the two second chips 102-1 and 102-2:
In the second overlapping region A2 of the second chip 102-1, the first partial region A2-1 and the first overlapping region A1 of the first chip 101-1 are overlapped and connected by using the direct interconnection structure 30. The second partial region A2-2 and the first partial region A1-1 in the first overlapping region A1 of the first chip 101-2 are overlapped and connected by using the direct interconnection structure 30.

The second overlapping region A2 of the second chip 102-2 and the second partial region A1-2 of the first chip 101-2 are overlapped and connected by using the direct interconnection structure 30.

The second non-overlapping region C2 of the second chip 102-1 does not overlap active surfaces of the two first chips 101-1 and 101-2, and the second non-overlapping region C2 of the second chip 102-1 is connected to the first routing structure 10 by using the vertical interconnection structure.

The second non-overlapping region C2 of the second chip 102-2 does not overlap the active surfaces of the two first chips 101-1 and 101-2, and the second non-overlapping region C2 of the second chip 102-1 is connected to the first routing structure 10 by using the vertical interconnection structure.

In other words, in a case in which the plurality of the second chips 102 are disposed in the chip stacking package 01, the second overlapping region A2 of each second chip 102 and the first overlapping region A1 of the at least one first chip 101 are connected by using the direct interconnection structure 30. The second non-overlapping region C2 of each second chip 102 does not overlap any active surface of the first chip 101, and the second non-overlapping region C2 of each second chip 102 is connected to the first routing structure 10 by using the vertical interconnection structure.

In addition, to reduce a thickness of the chip stacking package 01, the plurality of the first chips 101 may be embedded in the first routing structure 10. For an embedded manner of the plurality of the first chips 101, refer to the foregoing Embodiment 4.

An embedded depth of each of the plurality of the first chips 101 in the first routing structure 10 may be the same different. For example, each first chip 101 may penetrate the first routing structure 10 and be embedded in the first routing structure 10. For another example, a part of the first chips 101 penetrate the first routing structure 10 and are embedded in the first routing structure 10, and a part of the first chips 101 are embedded in the first routing structure 10 without penetrating the first routing structure 10.

In some possible embodiments, to simplify a manufacturing process, it may be disposed that an embedded depth of each first chip 101 in the first routing structure 10 is the same, so that all first chips 101 are embedded in the first routing structure 10 by using a same embedding process.

In the foregoing embodiments, the description of each embodiment has respective focuses. For a part that is not described in detail in an embodiment, refer to related description in another embodiment.

The process steps discussed in some of the foregoing embodiments of this application are merely some implementation methods used to describe feasibility of the structure in this application and do not limit the scope of this application. The chip stacking package of this application implemented by using other process methods or sequences shall also fall within the protection scope of this application.

The foregoing description is merely a specific implementation of this application, but is not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip stacking package, comprising: a first routing structure and a second routing structure that are disposed opposite to each other, and a first chip and a second chip that are disposed between the first routing structure and the second routing structure, wherein the first chip is in contact with the first routing structure, the second chip is disposed between the second routing structure and the first chip, and an active surface of the first chip faces an active surface of the second chip;
the active surface of the first chip comprises a first overlapping region and a first non-overlapping region, and the active surface of the second chip comprises a second overlapping region and a second non-overlapping region;
the first overlapping region overlaps the second overlapping region, and the first overlapping region is connected to the second overlapping region;
the first non-overlapping region does not overlap the active surface of the second chip, and the first non-overlapping region is connected to the second routing structure; and
the second non-overlapping region does not overlap the active surface of the first chip, and the second non-overlapping region is connected to the first routing structure.

2. The chip stacking package according to claim 1, wherein the first overlapping region and the second overlapping region are connected by using a direct interconnection structure, and the direct interconnection structure is a shortest interconnection structure connecting the first overlapping region and the second overlapping region.

3. The chip stacking package according to claim 2, wherein
the direct interconnection structure comprises a first micro-bump disposed in the first overlapping region, and a second micro-bump or a solder pad that is connected to the first micro-bump by using solder and that is disposed in the second overlapping region.

4. The chip stacking package according to claim 2, wherein the direct interconnection structure comprises a first solder pad disposed in the first overlapping region, and a second solder pad that is connected to the first solder pad and that is disposed in the second overlapping region, and a connection manner of the first solder pad and the second solder pad comprises hybrid bonding, surface activated bonding, or atomic diffusion bonding.

5. The chip stacking package according to claim 1, wherein the chip stacking package further comprises a third chip, and an active surface of the third chip faces the active surface of the second chip;
the active surface of the third chip comprises a third overlapping region and a third non-overlapping region;
a first partial region in the second overlapping region overlaps the first overlapping region, and a second partial region in the second overlapping region overlaps the third overlapping region;
the third overlapping region is connected to the second partial region by using a direct interconnection structure, and the first overlapping region is connected to the first partial region by using the direct interconnection structure;
the second non-overlapping region does not overlap the active surface of the third chip; and
the third non-overlapping region does not overlap the active surface of the second chip, and the third non-overlapping region is connected to the second routing structure.

6. The chip stacking package according to any one of claims 1 to 5, wherein the first non-overlapping region is connected to the second routing structure by using a vertical interconnection structure, or the first non-overlapping region is connected to the first routing structure by using wire bonding.

7. The chip stacking package according to any one of claims 1 to 6, wherein the first routing structure and the second routing structure are connected by using the vertical interconnection structure, and the vertical interconnection structure is one or more of a micro-bump, a copper pillar, a solder ball, and a controlled collapse chip connection structure.

8. The chip stacking package according to any one of claims 1 to 7, wherein
the first chip is disposed in the first routing structure in an embedded manner, or the first chip is disposed on the first routing structure.

9. The chip stacking package according to any one of claims 1 to 8, wherein
the first routing structure is a redistribution layer or a substrate on which a cabling pattern is disposed; and
the second routing structure is the redistribution layer or the substrate on which the cabling pattern is disposed.

10. A terminal device, comprising a printed circuit board and at least one chip stacking package according to any one of claims 1 to 9, wherein the chip stacking package is connected to the printed circuit board by using a connector.

11. A chip stacking package method, comprising:
disposing a first routing structure and a first chip that is in contact with the first routing structure;
bonding a second chip to the first chip, wherein an active surface of the second chip faces an active surface of the first chip, the active surface of the first chip comprises a first overlapping region and a first non-overlapping region, the active surface of the second chip comprises a second overlapping region and a second non-overlapping region, the first non-overlapping region does not overlap the active surface of the second chip, the second non-overlapping region does not overlap the active surface of the first chip, the first overlapping region overlaps the second overlapping region, the first overlapping region is connected to the second overlapping region, and the second non-overlapping region is connected to the first routing structure; and
disposing a second routing structure on the second chip, wherein the first non-overlapping region is connected to the second routing structure.

12. The chip stacking package method according to claim 11, wherein the first routing structure is a first redistribution layer;
the disposing a first routing structure and a first chip that is in contact with the first routing structure comprises:
sequentially forming a temporary bonding layer, the first redistribution layer on a carrier, and attaching the first chip to the first redistribution layer;
forming a temporary bonding layer on a carrier, disposing the first chip on the temporary bonding layer, and forming the first redistribution layer on the temporary bonding layer on which the first chip is disposed; or
forming a temporary bonding layer on a carrier, forming a partial cabling layer in the first redistribution layer on the temporary bonding layer, and attaching the first chip to the partial cabling layer, and forming a remaining cabling layer in the first redistribution layer on the partial cabling layer to which the first chip is attached.

13. The chip stacking package method according to claim 11, wherein the first routing structure is a first substrate on which a cabling pattern is disposed; and
the disposing a first routing structure and a first chip that is in contact with the first routing structure comprises:
manufacturing the first substrate on which the cabling pattern is disposed, and attaching the first chip to the first substrate.

14. The chip stack packaging method according to any one of claims 11 to 13, wherein before the bonding a second chip to the first chip, the method further comprises:
manufacturing, in the second non-overlapping region, a vertical interconnection structure connected to the first routing structure, or manufacturing, in the first routing structure, a vertical interconnection structure connected to the second non-overlapping region.
